# EUROPEAN PATENT SPECIFICATION

(11) **EP 1 981 076 B1**
(45) Date of publication and mention of the grant of the patent: **23.05.2012**
(21) Application number: 06834102.3
(22) Date of filing: 06.12.2006
(51) Int. Cl.: H01L 21/28, H01L 29/51, H01L 29/78, H01L 21/336

(54) **METHOD FOR MANUFACTURING SILICON CARBIDE SEMICONDUCTOR DEVICE**
VERFAHREN ZUR HERSTELLUNG EINER SILIZIUMCARBID-HALBLEITERANORDNUNG
PROCEDE DE FABRICATION D' UN DISPOSITIF SEMI-CONDUCTEUR AU CARBURE DE SILICIUM

(30) Priority: 30.01.2006 JP 2006020060
(43) Date of publication of application: 15.10.2008
(73) Proprietor: Sumitomo Electric Industries, Ltd., Osaka-shi, Osaka 541-0041 (JP)
(72) Inventor: MASUDA, Takeyoshi c/o Osaka Works of, Osaka-shi Osaka 5548511 (JP)
(74) Representative: Grünecker, Kinkeldey, Stockmair & Schwanhäusser
(86) International application number: PCT/JP2006/324347
(87) International publication number: WO 2007/086196

(56) References cited:
- WO-A-2005/053034
- JP-A- 11 274 487
- JP-A- 2001 345 320
- JP-A- 2002 280 381
- JP-A- 2003 124 208
- JP-A- 2003 243 653
- JP-A- 2005 019 951
- JP-A- 2005 019 951
- GOLZ A ET AL: "Electrical properties of oxides on silicon carbide grown by remote plasma chemical vapor deposition annealed in different gas ambients" MATERIALS SCIENCE AND ENGINEERING B, ELSEVIER SEQUOIA, LAUSANNE, CH, vol. 46, no. 1-3, 1 April 1997 (1997-04-01), pages 363-365, XP004085345 ISSN: 0921-5107

## Description

### TECHNICAL FIELD

The present invention relates to a method of manufacturing a silicon carbide semiconductor device such as an MOSFET, having a gate insulating film low in interface state density.

### BACKGROUND ART

Semiconductor devices such as a transistor and a diode formed with a silicon carbide substrate (SiC substrate) composed of silicon (Si) and carbon (C) bonded to each other at a composition ratio of 1:1 have been expected to go into actual use as power devices. As silicon carbide is a wide bandgap semiconductor, its breakdown electric field is higher than that of silicon by one order of magnitude. Accordingly, even if a depletion layer at a pn junction or a Schottky junction has a smaller thickness, a high peak inverse voltage can be maintained. Here, as use of the silicon carbide substrate permits smaller thickness of the device and higher doping concentration, implementation of a power device having a low ON resistance, a high withstand voltage, and low loss has been expected. It is noted that the silicon carbide substrate herein encompasses any substrate obtained by epitaxially growing a silicon carbide crystal layer on a substrate composed of silicon carbide crystals or a material different from silicon carbide.

Meanwhile, as compared with an MOSFET (Metal Oxide Semiconductor Field Effect Transistor) including a silicon substrate, an MOSFET including the silicon carbide substrate is disadvantageous in poor characteristics of a silicon oxide film serving as a gate insulating film, for the following reasons. Basically, as a large amount of carbon remains in a thermal oxidation film on the silicon carbide substrate, C-C bonds or dangling bonds are present, and consequently, interface state density in an interface region between the thermal oxidation film and a silicon carbide layer is high.

For addressing such a disadvantage, according to Japanese National Patent Publication No. 2004-511101 (Patent Document 1), for example, lower interface state density in an interface region between an oxide layer and a silicon carbide layer is achieved by oxidizing the silicon carbide layer in nitrous oxide (N₂O) and annealing the oxide layer on the silicon carbide layer in an N₂O atmosphere
Patent Document 1: Japanese National Patent Publication No. 2004-511101

### DISCLOSURE OF THE INVENTION

### PROBLEMS TO BE SOLVED BY THE INVENTION

According to Patent Document 1, nitrogen monoxide (NO) generated as a result of thermal decomposition through annealing in N₂O inactivates dangling bond of Si, C that is present in the interface region between an oxide film (oxide layer) and a semiconductor layer. Accordingly, the interface state serving as electron trap is lowered and carrier mobility is improved. According to the technique in Patent Document 1, however, reaction between N₂O and SiC should be caused at a temperature of 1100°C or higher, and therefore Patent Document is disadvantageous in poor throughput due to a long time required for temperature increase and decrease in an annealing furnace as well as in difficulty in maintaining uniformity of a temperature within a wafer.

Document JP 2005 019951 describes the manufacture of a gale oxide on SiC by first oxidizing in N₂O and then nitridizing in N₂.

An object of the present invention is to provide a method of manufacturing a silicon carbide semiconductor device having low interface state density with high throughput.

### MEANS FOR SOLVING THE PROBLEMS

A method of manufacturing a silicon carbide semiconductor device according to the present invention includes: an oxide film forming step of forming an oxide film serving as a gate insulating film on a silicon carbide layer formed on a substrate; and a plasma exposure step of exposing the oxide film to plasma generated by using a gas containing at least any one of ozone O₃ and nitrogen oxide NOₓ, after the oxide film forming step.

According to this method, functions such as inactivation of a dangling bond by an N atom and breaking of C-C bond by an O atom are attained, and therefore, interface state density in an interface region between an oxide film and a silicon carbide layer can be lowered through treatment at a relatively low temperature. In addition, as higher uniformity of plasma treatment within a wafer is more likely in the plasma exposure step than in annealing treatment, variation in the interface state density is also smaller. Therefore, in addition to improvement in channel mobility and lowering in a leakage current in an MOSFET or the like, variation in a threshold voltage of the MOSFET or the like is also smaller. Moreover, as the plasma exposure step can be performed at a relatively low temperature, throughput is also improved.

In the method of manufacturing a silicon carbide semiconductor device above, in the plasma exposure step, a gas containing ozone (O₃) is employed. Alternatively, a gas containing nitrogen oxide (NOx) is employed.

In the method of manufacturing a silicon carbide semiconductor device above, in the oxide film forming step, a silicon oxide film is preferably formed as the oxide film by heating the silicon carbide layer in an atmosphere containing at least oxygen element. In forming the gate insulating film, by forming the silicon oxide film through thermal oxidation in which the silicon carbide layer is heated to a high temperature in an atmosphere containing at least oxygen element, information on a crystalline state of the underlying silicon carbide layer is taken over to the silicon oxide film. The gate insulating film well adapted to the underlying layer is thus obtained. Here, a temperature for thermal oxidation treatment is preferably in a range from at least 1250°C to at most 1400°C.

In the oxide film forming step, the oxide film is preferably formed with chemical vapor deposition (CVD). In forming the gate insulating film, by forming the oxide film with CVD, the gate insulating film relatively low in the interface state density in the region of interface with the underlying silicon carbide layer is obtained.

The method of manufacturing a silicon carbide semiconductor device preferably further includes the step of planarizing the silicon carbide layer with chemical mechanical planarization (CMP) prior to the oxide film forming step. By planarizing the silicon carbide layer with CMP prior to forming the gate insulating film, distribution of the interface state density is made uniform, and the silicon carbide semiconductor device smaller in variation in the threshold voltage is obtained.

### EFFECTS OF THE INVENTION

According to the method of manufacturing a silicon carbide semiconductor device of the present invention, the silicon carbide semiconductor device having low interface state density in the interface region between the gate insulating film and the silicon carbide layer can be obtained.

### BRIEF DESCRIPTION OF THE DRAWINGS

Fig. 1 is a cross-sectional view showing a step of manufacturing an MOSFET in an embodiment.
Fig. 2 is a cross-sectional view showing a step of manufacturing the MOSFET in the embodiment.
Fig. 3 is a cross-sectional view showing a step of manufacturing the MOSFET in the embodiment.
Fig. 4 is a cross-sectional view showing a step of manufacturing the MOSFET in the embodiment.
Fig. 5 is a cross-sectional view showing a step of manufacturing the MOSFET in the embodiment.
Fig. 6 is a cross-sectional view showing a step of manufacturing the MOSFET in the embodiment.
Fig. 7 is a perspective view schematically showing a structure of a plasma apparatus used in the embodiment.

### DESCRIPTION OF THE REFERENCE SIGNS

10 4H-SiC substrate; 11 epitaxially grown layer; 12 p well region; 12a channel region; 13 source region; 15 p⁺ contact region; 20 gate insulating film; 21 source electrode; 22 gate electrode; 23 drain electrode; 50 plasma apparatus; 51 chamber; 52 tunnel; 53 upper electrode; 54 lower electrode; 61 wafer; and 62 wafer carrier.

### BEST MODES FOR CARRYING OUT THE INVENTION

### (Embodiment)

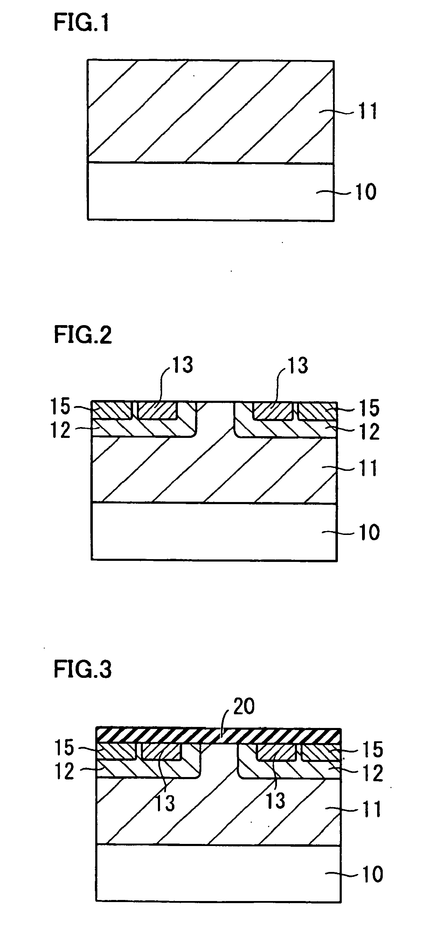

Figs. 1 to 6 are cross-sectional views showing steps of manufacturing an MOSFET representing a silicon carbide semiconductor device in an embodiment. Though Figs. 1 to 6 show solely two transistor cells representing a part of a vertical MOSFET, a large number of transistor cells are integrated to configure one vertical MOSFET.

In the step shown in Fig. 1, an n-type 4H (hexagonal)-SiC (4 represents the number of layers stacked in one period) substrate 10, for example, having a resistivity of 0.02Ωcm and a thickness of 400µm, and having a (0001) face at an off angle of approximately 8° in [11-20] direction as a main surface is prepared. Then, using CVD epitaxial growth including in-situ doping, an epitaxially grown layer 11, for example, containing an n-type dopant in a concentration of approximately 5×10¹⁵cm⁻³ and having a thickness of approximately 10µm is grown on 4H-SiC substrate 10. An outermost surface of epitaxially grown layer 11 immediately after epitaxial growth has an average surface roughness Ra, for example, of approximately 0.2nm to 0.3nm. It is noted herein that an individual orientation and an individual face are shown with [] and (), respectively.

Thereafter, in the step shown in Fig. 2, using ion implantation, a p well region 12, for example, containing a p-type dopant in a concentration of approximately 1×10¹⁹cm⁻³ and having a thickness (depth) of approximately 1.0µm is formed in a part of a surface portion of epitaxially grown layer 11. Further using ion implantation, a source region 13, for example, containing an n-type dopant in a concentration of 1×10¹⁹cm⁻³ and having a thickness (depth) of approximately 0.3µm and a p⁺ contact region 15, for example, containing a p-type dopant in a concentration of 5×10¹⁹ cm⁻³ and having a thickness (depth) of approximately 0.3µm are formed in each part of the surface portion of p well region 12. Here, the temperature of 4H-SiC substrate 10 and epitaxially grown layer 11 during ion implantation is set, for example, to 500°C. Thereafter, an abrasive mainly containing colloidal silica is used to perform CMP (chemical mechanical planarization), to thereby remove the surface portion of the substrate, for example, by approximately 1nm to 5nm. The outermost surface of epitaxially grown layer 11 immediately after CMP has average surface roughness Ra, for example, in a range from approximately 0.1nm to 0.5nm. Though not shown, in general, after these steps, a sacrificial oxide film is formed on the substrate using thermal oxidation, and thereafter the sacrificial oxide film is removed, and then the process proceeds to a next step.

Thereafter, in the step shown in Fig. 3, for example, using thermal oxidation, a gate insulating film 20 formed as the silicon oxide film having a thickness of approximately 50nm is formed on 4H-SiC substrate 10. Here, gate insulating film 20 is preferably formed through heating to a high temperature in an atmosphere containing at least oxygen element (O). Here, for example, O₂, O₃, N₂O, and the like may be employed as the gas containing oxygen element. Through heating in the atmosphere containing oxygen element, an oxide film higher in quality than a film formed with sputtering or CVD can be obtained. Heating to a high temperature in a range from at least 1250°C to at most 1400°C is preferably performed. Heating to a high temperature not lower than 1250°C can bring-about lower interface state density at an interface between gate insulating film 20 and each layer within epitaxially grown layer 11 (in particular, p well region 12). Heating to a high temperature not higher than 1400°C can suppress roughness of the surface of each layer within epitaxially grown layer 11. By performing thermal oxidation in the atmosphere containing oxygen element and nitrogen element, the interface state density at the interface between gate insulating film 20 and each layer within epitaxially grown layer 11 (in particular, p well region 12) can also be lowered. By thus employing the gas containing nitrogen element and oxygen element (such as N₂O and NO), the following function and effect is obtained, as compared with oxidation using solely oxygen element. Specifically, as remaining carbon from which the interface state originates is nitrided to attain a passivation function, further lower interface state density can be achieved.

Instead of thermal oxidation, for example, CVD (chemical vapor deposition) may be employed. As the underlying silicon carbide layer is hardly altered in CVD, gate insulating film 20 achieving relatively low interface state density in the region of interface with the underlying silicon carbide layer is obtained. Therefore, as far as only an effect to lower the interface state density is concerned, CVD is preferred.

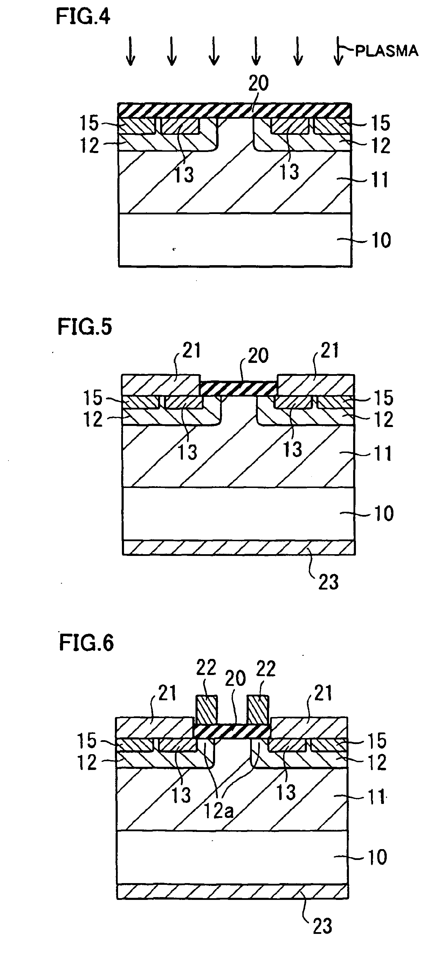

Thereafter, in the step shown in Fig. 4, with the use of a barrel type plasma apparatus, a gas containing at least any one of nitrogen element and oxygen element is employed to generate plasma for plasma treatment of gate insulating film 20 (plasma exposure step). In the plasma exposure step a gas containing O₃ is employed. Thus, passivation or removal (elimination) of carbon remaining at the interface between the oxide film and each layer within epitaxially grown layer 11 can be achieved. Alternatively, NOₓ is employed. By doing so, passivation or removal (elimination) of carbon remaining at the interface between the oxide film and each layer within epitaxially grown layer 11 can also similarly be achieved.

The plasma exposure step is not particularly limited, so long as plasma is generated by using the gas containing at least any one of O₃ and NOₓ. The gas containing at least any one of O₃ and NOₓ may further contain, for example, hydrogen or the like.

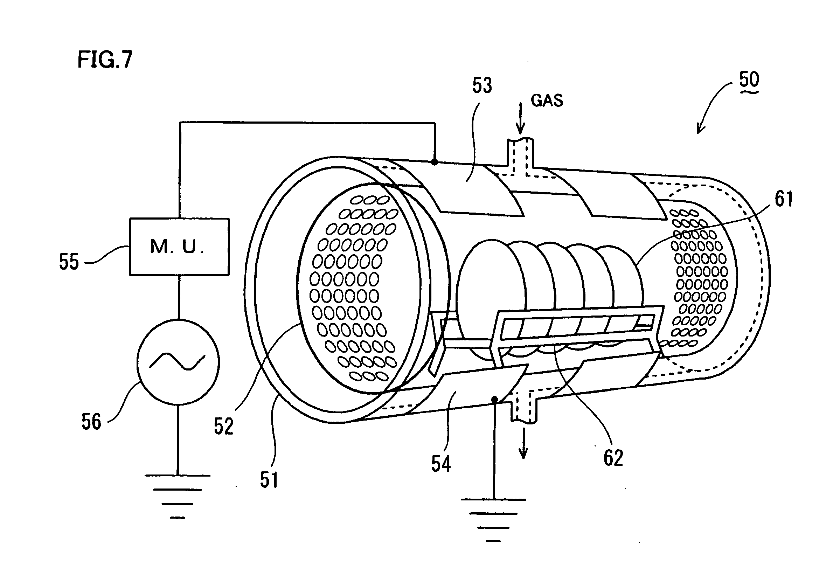

Fig. 7 is a perspective view schematically showing a structure of a plasma apparatus 50 used in the embodiment. Plasma apparatus 50 includes a chamber 51 formed with a quartz tube or the like, a tunnel 52 formed with an aluminum mesh tube or the like provided in chamber 51, an upper electrode 53 attached to a ceiling portion of chamber 51, and a lower electrode 54 attached to a bottom portion of chamber 51. Upper electrode 53 is connected to a high-frequency power supply with a matching unit 55 being interposed, and lower electrode 54 is connected to ground. A plurality of wafers 61 vertically placed on a wafer carrier 62 are arranged in tunnel 52.

Thereafter, in the step shown in Fig. 5, a portion of gate insulating film 20 located above source region 13 and p⁺ contact region 15 is removed, and thereafter, a source electrode 21 formed by a nickel (Ni) film having a thickness of approximately 0.1 µm is formed in a region from which gate insulating film 20 has been removed, for example, with a lift-off method.

Thereafter, in the step shown in Fig. 6, for example, by performing heat treatment at a temperature of 975°C for 2 minutes in an argon (Ar) atmosphere, a contact characteristic between Ni composing source electrode 21 and a drain electrode 23 and silicon carbide composing the underlying layer (source region 13, p⁺ contact region 15 and 4H-SiC substrate 10) is changed from Schottky contact to Ohmic contact. Thereafter, a gate electrode 22 composed of Al is formed on gate insulating film 20, spaced apart from source electrode 21.

Through the manufacturing steps above, an n-channel vertical MOSFET attaining a function as a power device is formed. In the vertical MOSFET, a region located in the uppermost portion of p well region 12 and under gate electrode 22 with gate insulating film 20 being interposed attains a function as a channel region 12a. When the MOSFET turns on, the current supplied from drain electrode 23 flows in the vertical direction from 4H-SiC substrate 10 to the uppermost portion of epitaxially grown layer 11, and thereafter the current reaches source region 13 through channel region 12a in the uppermost portion of p well region 12. Here, in channel region 12a, electrons, i.e., carriers, run from source region 13 toward the uppermost portion of epitaxially grown layer 11. Mobility of electrons in channel region 12a refers to channel mobility.

In the step of forming the gate oxide film shown in Fig. 3 of the present embodiment, CO or CO₂ volatilizes as a result of bonding between C atoms in epitaxially grown layer 11 (SiC layer) and O atoms, while a silicon oxide film (SiO₂) is formed as a result of bonding between Si atoms with O atoms. Here, unlike thermal oxidation at the surface of an Si layer, a large number of C atoms remain after thermal oxidation treatment of the surface of the SiC layer. Accordingly, a large number of dangling bonds of Si, C or C-C bonds representing bonding between C atoms are present in the interface region between the gate oxide film and the silicon carbide layer. Consequently, a large number of interface state densities are present in a region around the interface between the gate oxide film and the silicon carbide layer.

In the plasma treatment step shown in Fig. 4, the treatment temperature is set to approximately 100°C, and treatment at a high temperature around 1100°C is not necessary as in the technique of Patent Document 1. Therefore, high throughput can also be maintained.

A barrel type plasma generation apparatus is more advantageous as a plasma generation apparatus than a parallel plate type plasma generation apparatus, because damage to a gate insulating film and the like is less likely. Damage can be suppressed also by employing ICP (Inductively Coupled Plasma).

In the step shown in Fig. 2, thermal oxidation is preferably performed at a temperature in a range from at least 1250°C to at most 1400°C. This is because, as the temperature is higher, an effect to lower the interface state density is greater. Here, an atmosphere containing O₂, an atmosphere containing NO₂, an atmosphere containing N₂O, or the like may be selected for use as the atmosphere.

### (Other embodiments)

In the embodiment above, an example in which the silicon carbide semiconductor device according to the present invention is applied to an MOSFET (DMOSFET) has been described, however, the silicon carbide semiconductor device according to the present invention is also applicable to a VMOSFET, a UMOSFET, an IGBT, and the like.

In addition, in the embodiment above, an example in which the present invention is applied to an inversion mode MOSFET has been described, however, the present invention is applicable also to an accumulation mode MOSFET Moreover, in the embodiment above, an example in which the present invention is applied to a vertical MOSFET has been described, however, the present invention is applicable also to a lateral MOSFET, Here, the drain region opposed to the source region with the channel region being interposed is formed in the surface portion of the epitaxially grown layer.

The substrate in the present invention is not limited to a 4H-SiC substrate, and an SiC substrate of a poly type different from 4H poly type, such as a 6H-SiC substrate (the number of layers stacked in one period is 6) or a substrate made of a material different from those for the SiC substrate, such as an Si substrate, may be adopted. For example, by applying the present invention also to a silicon carbide semiconductor device including a 3C-SiC epitaxially grown layer hetero-epitaxially grown on an Si substrate, an MOSFET small in variation in a threshold voltage or a Schottky diode of high withstand voltage can be obtained.

### INDUSTRIAL APPLICABILITY

The silicon carbide semiconductor device according to the present invention may be utilized for an MOSFET, an IGBT, and the like used as a power device or a high-frequency device.

## Claims

1. A method of manufacturing a silicon carbide semiconductor device, comprising:
an oxide film forming step of forming an oxide film (20) serving as a gate insulating film on a silicon carbide layer (11) formed on a substrate; and
a plasma exposure step of exposing said oxide film (20) to plasma generated by using a gas containing at least any one of ozone O₃ and nitrogen oxide NOₓ, after said oxide film forming step.

2. The method of manufacturing a silicon carbide semiconductor device according to claim 1, wherein in said plasma exposure step, said gas further contains hydrogen.

3. The method of manufacturing a silicon carbide semiconductor device according to claim 1, wherein in said oxide film forming step, a silicon oxide film is formed as said oxide film (20) by heating said silicon carbide layer in an atmosphere containing at least oxygen element.

4. The method of manufacturing a silicon carbide semiconductor device according to claim 3, wherein in said oxide film forming step, thermal oxidation is performed at a temperature in a range from at least 1250 deg. C to at most 1400 deg. C.

5. The method of manufacturing a silicon carbide semiconductor device according to claim 1, wherein in said oxide film forming step, said oxide film (20) is formed with chemical vapor deposition.

6. The method of manufacturing a silicon carbide semiconductor device according to claim 1, further comprising the step of planarizing said silicon carbide layer (11) with chemical mechanical planarization prior to said oxide film forming step.

## Patentansprüche

1. Verfahren zum Herstellen einer Siliziumkarbid-Halbleitervorrichtung, das umfasst:
einen Schritt zum Ausbilden eines Oxid-Films, in dem ein Oxid-Film (20, der als ein Gate-Isolierfilm dient, auf einer Siliziumkarbid-Schicht (11) ausgebildet wird, die auf einem Substrat ausgebildet ist; und
einen Plasmabehandlungsschritt, in dem der Oxid-Film (20) mit Plasma behandelt wird, das unter Verwendung eines Gases erzeugt wird, das Ozon (O₃) oder/und Stickstoffoxid (NOₓ) enthält, nach dem Schritt zum Ausbilden eines Oxid-Films.

2. Verfahren zum Herstellen einer Siliziumkarbid-Halbleitervorrichtung nach Anspruch 1, wobei in dem Plasmabehandlungsschritt das Gas des Weiteren Wasserstoff enthält.

3. Verfahren zum Herstellen einer Siliziumkarbid-Halbleitervorrichtung nach Anspruch 1, wobei in dem Schritt zum Ausbilden eines Oxid-Films ein Siliziumoxid-Film als der Oxid-Film (20) ausgebildet wird, indem die Siliziumkarbid-Schicht in einer Atmosphäre erhitzt wird, die wenigstens elementaren Sauerstoff enthält.

4. Verfahren zum Herstellen einer Siliziumkarbid-Halbleitervorrichtung nach Anspruch 3, wobei in dem Schritt zum Ausbilden eines Oxid-Films thermische Oxidation bei einer Temperatur in einem Bereich von wenigstens 1250 °C bis höchstens 1400 °C durchgeführt wird.

5. Verfahren zum Herstellen einer Siliziumkarbid-Halbleitervorrichtung nach Anspruch 1, wobei in dem Schritt zum Ausbilden eines Oxid-Films der Oxid-Film (20) mit chemischer Aufdampfung ausgebildet wird.

6. Verfahren zum Herstellen einer Siliziumkarbid-Halbleitervorrichtung nach Anspruch 1, das des Weiteren den Schritt des Planarisierens der Siliziumkarbid-Schicht (11) mit chemischmechanischer Planarisierung vor dem Schritt zum Ausbilden eines Oxid-Films umfasst.

## Revendications

1. Procédé de fabrication d'un dispositif à semi-conducteurs en carbure de silicium, comprenant :
une étape de formation d'un film d'oxyde consistant à former un film d'oxyde (20) servant de film isolant de grille sur une couche de carbure de silicium (11) formée sur un substrat ; et
une étape d'exposition à un plasma consistant à exposer ledit film d'oxyde (20) à un plasma produit au moyen d'un gaz contenant au moins un gaz quelconque parmi l'ozone O₃ et l'oxyde d'azote NOₓ, après ladite étape de formation d'un film d'oxyde.

2. Procédé de fabrication d'un dispositif à semi-conducteurs en carbure de silicium selon la revendication 1, dans lequel dans ladite étape d'exposition à un plasma, ledit gaz contient en outre de l'hydrogène.

3. Procédé de fabrication d'un dispositif à semi-conducteurs en carbure de silicium selon la revendication 1, dans lequel dans ladite étape de formation d'un film d'oxyde, on forme un film d'oxyde de silicium en tant que ledit film d'oxyde (20) par chauffage de ladite couche de carbure de silicium dans une atmosphère contenant au moins l'élément oxygène.

4. Procédé de fabrication d'un dispositif à semi-conducteurs en carbure de silicium selon la revendication 3, dans lequel dans ladite étape de formation d'un film d'oxyde, on réalise une oxydation thermique à une température comprise dans une plage allant d'au moins 1250 °C à 1400 °C au plus.

5. Procédé de fabrication d'un dispositif à semi-conducteurs en carbure de silicium selon la revendication 1, dans lequel dans ladite étape de formation d'un film d'oxyde, on forme ledit film d'oxyde (20) par un dépôt chimique en phase vapeur.

6. Procédé de fabrication d'un dispositif à semi-conducteurs en carbure de silicium selon la revendication 1, comprenant en outre l'étape de planarisation de ladite couche de carbure de silicium (11) par un polissage mécanochimique avant ladite étape de formation d'un film d'oxyde.
